# EUROPEAN PATENT APPLICATION

(11) **EP 4 703 767 A1**
(43) Date of publication of application: **04.03.2026**
(21) Application number: 25196349.2
(22) Date of filing: 18.08.2025
(51) Int. Cl.: G01S 13/58, H03M 7/30

(54) **RADAR DATA COMPRESSION USING HYBRID SPECTRAL TRANSFORMATION**

(30) Priority: 30.08.2024 US 202418820777
(71) Applicant: NXP B.V., 5656 AG Eindhoven (NL)
(72) Inventor: Hekstra, Andries Pieter, 5656AG Eindhoven (NL)
(74) Representative: Colaiuda, Antonella

(57) **Abstract**

Methods and systems are provided for efficient radar data compression and reconstruction. A radar processing unit receives and digitizes radar signals reflected from one or more objects, storing a first set of indexed samples while omitting a second set from storage. Sets of cross-correlation values are calculated between the second set of samples and the first set of samples within a local sliding window context. These values are used to reconstruct the second set of samples. The reconstructed and stored samples are then utilized to generate a radar map (such as a range-velocity map, range-Doppler map, or range-angle map, depending on the radar-cube axis of compression).

## Description

### BACKGROUND

In modern radar systems (including automotive radar systems), accurate detection and tracking of objects are critical for various applications, including driver-assistance systems and autonomous driving. These systems rely on radar sensors to capture and process large amounts of data such as range, velocity, and angular information about the surrounding environment. The collected data is typically referred to as a radar data cube.

The efficient storage and processing of the radar data cube is a significant challenge associated with these radar systems. The large volume of data generated requires substantial memory resources. As automotive radar systems-on-chip (SOCs) integrate more antennas and increase their data resolution, the demand for memory increases proportionally, leading to higher costs and power consumption. Moreover, the need to preserve critical information for accurate direction-of-arrival (DoA) estimation and velocity measurement, including phase information for one or more signals, further complicates the data handling process.

Current practices in radar data storage typically involve storing the entire radar data cube, including all fast-time and slow-time samples. While this approach ensures that all relevant information is retained, it also results in significant memory consumption. Various data compression techniques have been explored to address this issue, including lossy and lossless methods. However, these methods often face limitations, such as the inability to preserve phase information or the requirement for complex reconstruction processes.

### BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.
FIG. 1 illustrates a Frequency Modulated Continuous Wave (FMCW) radar system.
FIG. 2 illustrates aspects of data compression techniques in accordance with one or more embodiments.
FIG. 3 illustrates a high-level block diagram of a radar system-on-chip (SoC), in accordance with some embodiments.
FIGs. 4-1 and 4-2 depict single-antenna range-velocity maps illustrating range and velocity information derived from radar signal processing, in accordance with some embodiments.
FIG. 5 depicts an operational routine for compressing radar data and generating a range-velocity map based on the compressed data, in accordance with some embodiments.

### DETAILED DESCRIPTION

A radar data cube is typically formed by sampling radar signals over multiple dimensions: range (fast-time), velocity (slow-time), and spatial (antenna array). Fast-time sampling captures the time delay of the reflected signal, providing range information. Slow-time sampling involves capturing data over multiple radar pulses or chirps, enabling velocity estimation through Doppler processing. The spatial dimension is determined by signals received from multiple antenna elements, allowing for direction of arrival (DoA) estimation.

Embodiments of techniques described herein reduce the memory footprint of radar data cubes while maintaining the integrity of essential information, thereby balancing memory usage, computational complexity, and the accuracy of the reconstructed data. Such embodiments enable the deployment of high-resolution radar systems in cost-sensitive and power-constrained applications, including automotive applications, and can be utilized in a variety of radar signal scenarios. As non-limiting examples, techniques described herein may be utilized to reduce the memory footprint of radar data cubes in FMCW systems, phase-modulated continuous wave (PMCW) systems, pulse-based systems, spread spectrum systems, orthogonal frequency-division multiplexing (OFDM) systems, ultra-wideband systems, etc.

In certain embodiments, data compression is utilized to reduce the memory footprint of radar data cubes while preserving essential signal characteristics, such as phase information. For example, techniques described herein involve storing a subset of the slow-time samples (such as even-indexed samples, odd-indexed samples, or other subset) and using cross-correlation techniques to reconstruct the omitted (e.g., odd-indexed) samples. By leveraging these techniques, the described embodiments balance memory efficiency and data integrity, facilitating more efficient processing and storage of radar data in automotive and other radar systems. The disclosed embodiments may also be adaptable to different radar system configurations and can be applied in various scenarios in which reduced data storage and computational efficiency are desirable. Furthermore, it will be appreciated that while various techniques are described herein with respect to data samples indexed along the slow-time axis of the radar data cube, in various embodiments and scenarios such techniques may be performed with respect to the fast-time and/or spatial axes as well.

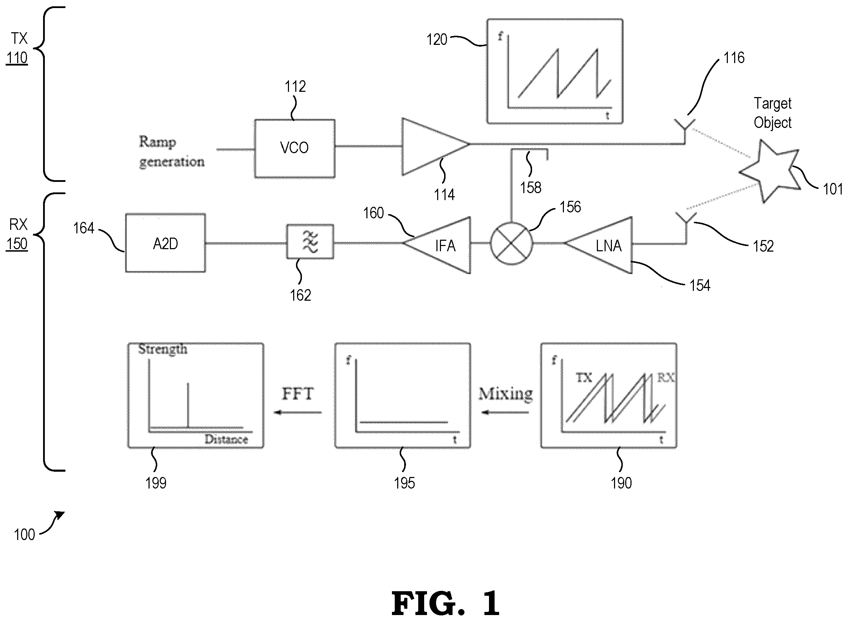

FIG. 1 illustrates a Frequency Modulated Continuous Wave (FMCW) radar system 100, which includes component circuitry for generating, transmitting, receiving, and processing radar signals. The FMCW radar system 100 is designed to detect and measure various attributes of a target object 101. In one or more embodiments, the FMCW radar system 100 is an automotive radar system that maybe implemented as part of a vehicle and that may be configured for use in one or more civil automotive applications.

The radar system 100 comprises a transmission section 110 and a reception section 150. The transmission section 110 includes a Voltage Controlled Oscillator (VCO) 112, which generates a highly linear frequency ramp signal 120. This ramp signal 120 is amplified by a power amplifier 114 and transmitted through a transmit antenna 116 towards the target object 101.

As the transmitted signal propagates and reflects off the target object 101, it returns to the radar system 100, where it is received by a receive antenna 152. The received signal then passes through a Low Noise Amplifier (LNA) 154, which amplifies the weak signal. The amplified signal is then mixed with the transmitted signal in a mixer 156 to produce an intermediate frequency (IF) signal, also known as the beat signal.

A feedback path 158 is included in the system, providing a portion of the transmitted signal from the transmission section 110 to the mixer 156. This feedback mechanism allows the transmitted signal to be compared with the received signal, facilitating the generation of the IF signal. The beat frequency, which is proportional to the distance to the target object 101, is extracted through this process.

The IF signal is further processed through an Intermediate Frequency Amplifier (IFA) 160, which removes high-frequency noise from the signal, and a Low Pass Filter (LPF) 162, which removes unwanted high-frequency components from the signal. The filtered signal is then digitized by an Analog-to-Digital Converter (ADC) 164, converting the analog signal into digital form for subsequent processing.

The digitized signal 190 undergoes a Fast Fourier Transform (FFT) 195 to convert it from the time domain to the frequency domain, enabling the detection of objects at different distances and velocities, represented as peaks in the resulting spectrum. The range information is then derived (199) from the FFT output, and the strength of the reflected signal is used to determine the characteristics of the target object 101.

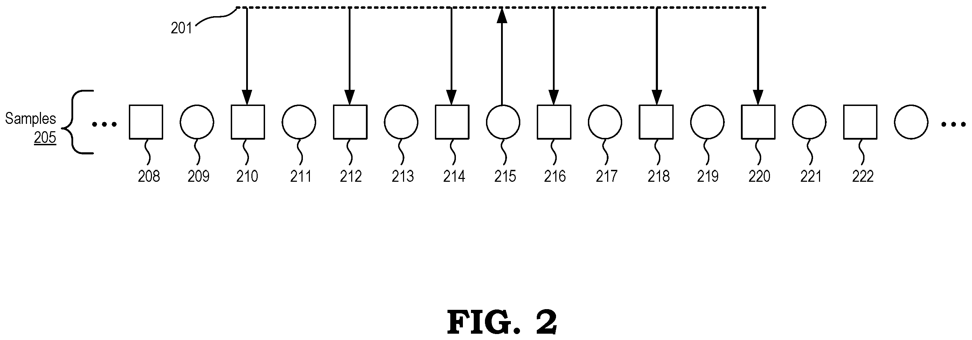

FIG. 2 illustrates aspects of data compression techniques used in one or more embodiments, advantageously leveraging the relationship between even-indexed samples (e.g., 208, 210, 212, 214, 216, 218, 220) and odd-indexed samples (e.g., 209, 211, 213, 215, 217, 219, 221) along the slow-time axis. The data samples 205 represent a sequence of data points obtained from radar signal processing, such that each data point corresponds to a specific time instance.

In the illustrated embodiment, even-indexed samples represented by squares are retained and stored, while odd-indexed samples, represented by circles, are omitted from storage. The selection of these samples follows a periodic pattern, where each stored even-indexed sample is followed by an omitted odd-indexed sample.

A cross-correlation 201 is performed between each omitted odd-indexed sample and its local context of stored even-indexed samples. For example, the omitted sample 215 is correlated with six neighboring even-indexed samples within a local sliding window, including samples 210, 212, 214, 216, 218, and 220. This use of a sliding window context helps capture the relationships between the omitted and stored samples over a small range of the signal while storing only six cross-correlation values per omitted sample, significantly reducing the storage space required for those even-indexed samples. In certain embodiments, the cross-correlation values are recorded and utilized in a subsequent reconstruction step, allowing for the estimation of the omitted samples based on the stored samples.

The choice of using cross-correlation offers significant advantages over the use of auto-correlation in this context. Cross-correlation measures the similarity between two different signals-in this case, the omitted odd-indexed samples and the surrounding stored even-indexed samples. This technique preserves the phase information of the signals, which enables the incorporating radar system to accurately determine parameters such as direction of arrival (DoA) and velocity. In contrast, auto-correlation involves comparing a signal with a delayed version of itself. While auto-correlation can reduce the number of data points needed for storage, it tends to lose phase information because it involves the multiplication of the signal with its complex conjugate. This loss of phase information can lead to inaccuracies in the reconstructed data, particularly in applications where phase plays a role in the interpretation of the signal, such as in DoA estimation and Doppler processing.

As one non-limiting example, a value of an omitted odd-indexed sample, such as sample 215, is predicted using a set of neighboring even-indexed samples 210, 212, 214, 216, 218, and 220. The prediction is accomplished by applying the normal equations method within the sliding window context of those samples. In the normal equations method, a matrix-vector equation is constructed where the left-hand side matrix consists of the auto-correlation values of the stored even-indexed slow-time samples, such as samples 210, 212, 214, 216, 218, and 220. This matrix often takes the form of a Toeplitz matrix, characterized by constant diagonals. A Toeplitz matrix is a type of matrix in which each descending diagonal from left to right is constant. This means that all elements along a diagonal have the same value. Formally, a matrix *T* is called a Toeplitz matrix if T[i,j]=T[i+1,j+1] for all valid indices *i* and *j*, such that the value of the matrix element depends only on the difference between the column and row indices. The Toeplitz structure is advantageous because it allows for the application of well-known complexity reduction techniques (e.g., the Levinson-Durbin algorithm) to efficiently solve the matrix-vector equation.

In certain embodiments, the right-hand side of such a matrix-vector equation comprises the cross-correlation values between the omitted odd-indexed sample (e.g., 215) and the stored even-indexed samples (samples 210, 212, 214, 216, 218, and 220) from the same local sliding window context. Solving this system of equations yields the linear prediction coefficients, which are then used to weight the even-indexed samples for predicting the value of the omitted sample. This solution ensures that the reconstructed signal maintains high fidelity to the original, including phase information.

In certain embodiments, separate Mean Square Error (MSE) prediction vectors are generated for each column of odd-indexed sub-sequences within the data cube, corresponding to different range indices. The area required for the cross-correlation calculations and the MSE prediction decompression computations is relatively small compared to the area required for the original memory needed to store all sample data (both even- and odd-indexed samples). As a result, the overall integrated circuit (IC) area savings can be substantial. Alternatively, if the original memory area is retained, the described techniques enable the storage of approximately twice the number of slow-time samples, effectively doubling the data cube's capacity without increasing the physical memory size.

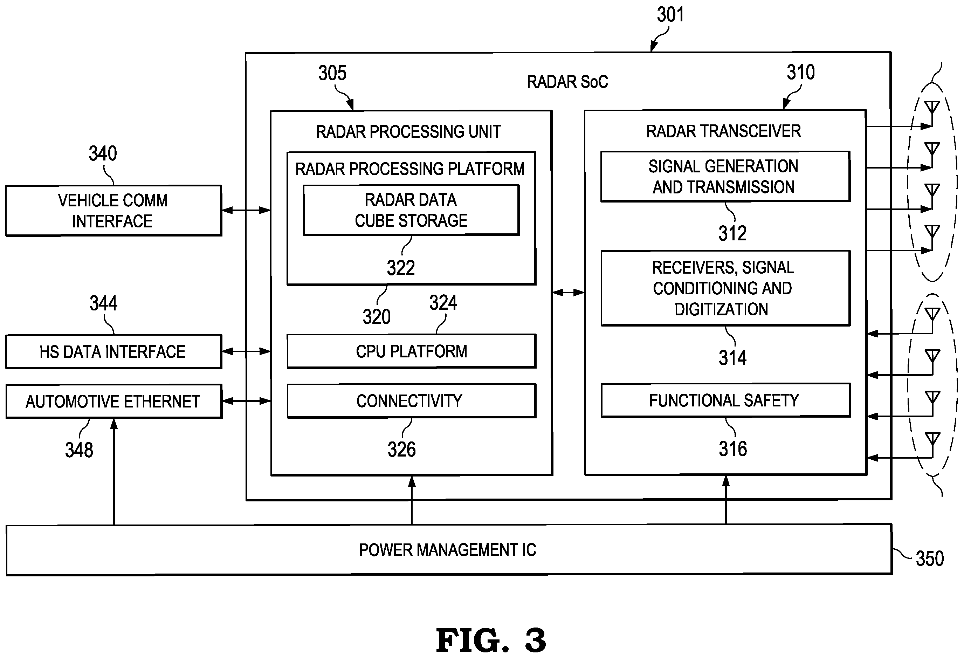

FIG. 3 illustrates a high-level block diagram of a radar system-on-chip (SoC) 301, which integrates various circuitry components utilized for radar signal processing and system management. In this and other embodiments, techniques described herein leverage the integrated design of the radar SoC 301 to efficiently manage radar data.

In the depicted embodiment, the radar SoC 301 comprises a radar processing unit 305 and a radar transceiver 310, alongside communicatively coupled peripheral interfaces and power management circuitry 350. The radar processing unit 305 is configured to handle data processing and control functions. In various embodiments, the radar processing unit 305 comprises one or more microcontroller units (MCUs), central processing units (CPUs), digital signal processors (DSPs), application-specific integrated circuits (ASICs), and/or other types of hardware processors. Within the radar processing unit 305, the radar processing platform 320 encompasses radar signal processing tools and hardware necessary for managing radar data. Notably, a substantial portion of the radar processing platform 320 is allocated to a radar data cube storage 322 (sometimes referred to herein as a "computer-readable memory device 322"). The radar data cube storage 322 corresponds to a memory storage area that is designated for storing the radar data cube, which includes processed radar signals over multiple dimensions such as range, velocity, and angle. For example, the radar data cube storage 322 may store a range-Doppler antenna cube that is generated by the radar processing unit 305 by performing range compression (e.g., fast-time FFT) and Doppler compression (e.g., slow-time FFT) on samples (e.g., ADC samples) of reflected radar signals received via the antennas 315. In one or more embodiments, extensive IC area may be devoted to radar data cube storage, as it is generally desirable to efficiently manage and store this data, given its significant memory requirements. In one or more embodiments, the radar data cube storage 322 may include random access memory (RAM), such as SRAM, as a non-limiting example.

While in the present example the radar processing unit 305 and the radar transceiver 310 are shown to be included in the same radar SoC 301, it should be understood that this arrangement is intended to be illustrative and not limiting. For example, in one or more other embodiments, the radar processing unit 305 and the radar transceiver 310 are instead implemented as separate components that are communicatively and electrically coupled together and that are not part of the same SoC. While, in the present example, the radar data cube storage 322 is shown to be implemented as part of the radar processing unit 305, it should be understood that this is illustrative and non-limiting. For example, in one or more other embodiments, the radar data cube storage 322 may be implemented via a memory or other computer-readable data storage device that is coupled to the radar processing unit.

In the depicted embodiment, the radar processing unit 305 incorporates a CPU platform 324, which manages the execution of software and control algorithms for radar operations and overall system functionality. The connectivity circuitry 326 within the radar processing unit facilitates communication between different parts of the system and external interfaces (*e.g.*, vehicle communication interface 340, high-speed data interface 344, and automotive ethernet interface 348), supporting various communication protocols and interfaces.

The radar transceiver 310 section is responsible for signal generation, transmission, reception, and initial signal conditioning. Within the radar transceiver 310, the signal generation & transmission circuitry 312 generates the radar signals that are transmitted through the antenna array. The signal conditioning & digitization circuitry 314 captures the reflected radar signals, performs signal conditioning, and digitizes the received signals for further processing. In one or more embodiments, the signal conditioning & digitization circuitry 314 includes at least one analog-to-digital converter (ADC) that samples and digitizes the reflected radar signals to produce digital ADC samples representing the reflected radar signals.

Functional safety circuitry block 316 ensures that the system operates safely, even in the presence of faults or failures, by monitoring system health and implementing necessary safety measures to prevent hazardous situations. In various embodiments, the functional safety circuitry block 316 provides various additional state management, such as compliance with one or more relevant safety standards (e.g. ISO 26262 for automotive systems), and/or to prevent false detections or missed detections from affecting vehicle control decisions.

The radar SoC 301 interfaces with external components through several interfaces. The vehicle communication interface 340 allows communication with the vehicle's internal networks, such as controller area network (CAN) and other automotive communication protocols. The high-speed data interface 344 provides a high-speed communication link for data transfer between the radar system and other vehicle systems. Automotive Ethernet 348 facilitates data communication over Ethernet, supporting high-bandwidth data transfer requirements.

Power management within the radar SoC 301 is handled by the power management circuitry 350, which regulates and manages power distribution to ensure efficient and reliable operation.

The radar transceiver 310 interfaces with multiple antenna arrays. Transmit antennas 313 are used for transmitting radar signals generated by the signal generation & transmission circuitry 312. Receive antennas 315 are utilized for receiving reflected radar signals, which are then processed by the signal conditioning & digitization circuitry 314.

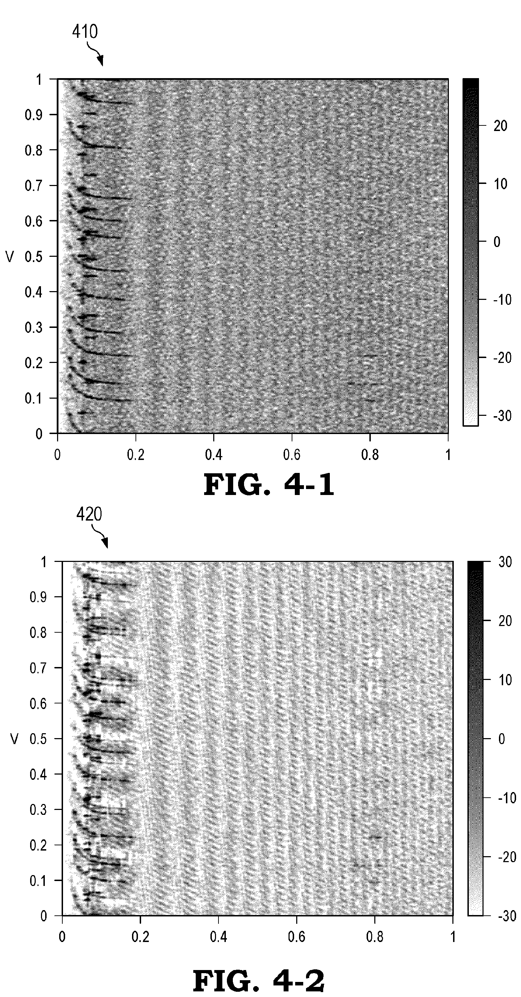

FIGs. 4-1 and 4-2 depict single-antenna range-velocity maps, illustrating the range and velocity information derived from radar signal processing. These figures provide visual representations of the radar data in a two-dimensional plot, in which the horizontal axis represents range (r) and the vertical axis represents velocity (v). The gradated scale on the right side of each figure indicates the intensity or magnitude of the radar signal, with varying shades representing different levels of signal strength.

FIG. 4-1 shows the range-velocity map 410 obtained without the application of data compression techniques. The range-velocity map 410 serves as a baseline, presenting the full radar data as captured by the single antenna system. The continuous distribution of intensity across the range-velocity map 410 indicates the presence of multiple detected objects or targets, with variations in both range and velocity. The variations correspond to different signal strengths, which relate to the distance and reflectivity of the detected objects.

FIG. 4-2 presents a range-velocity map 420 after applying data compression and subsequent decompression techniques described in the present disclosure to the range-velocity map 410. The range-velocity map 420 demonstrates the ability to reconstruct the radar data cube after such compression, allowing for the retention of critical information about the targets' range and velocity. The comparison between FIG. 4-1 and FIG. 4-2 highlights the effectiveness of the compression technique in preserving the fidelity of the original radar data while reducing the storage requirements. The preserved features in 4-2, as compared to FIG. 4-1, show the retention after decompression of characteristics such as target location and velocity, without significant loss of detail.

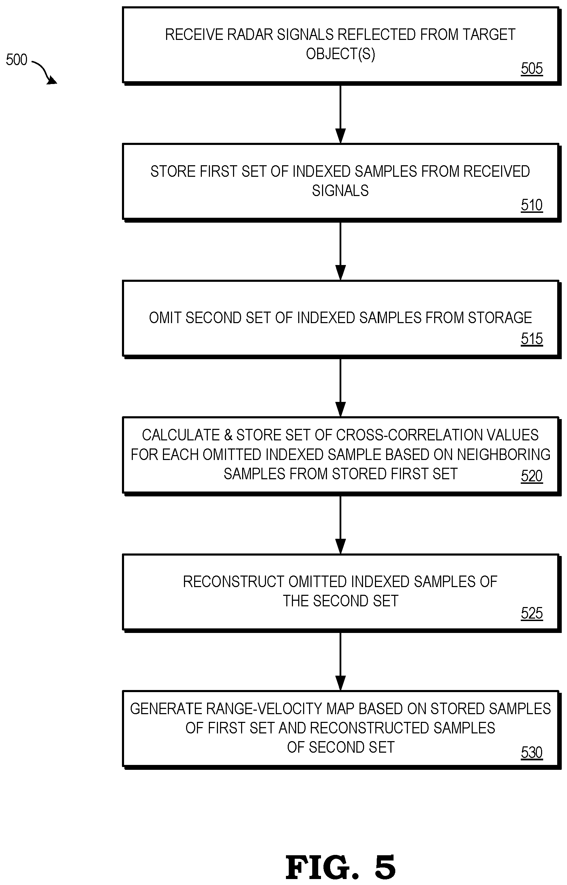

FIG. 5 depicts an operational routine 500 for compressing radar data and generating a range-velocity map based on the compressed data. The operational routine 500 may be performed, for example, by a radar system similar to radar SoC system 301 of FIG. 3.

The operational routine 500 begins at block 505, in which the radar system receives radar signals reflected from one or more target objects. The received radar signals contain information about the target objects' positions and velocities. In certain embodiments, the reception of such radar signals includes one or more preprocessing stages, such as the removal of noise, removal of unwanted frequency components, digitization, and/or transformation (e.g., to convert the received signals from time domain to the frequency domain). The routine proceeds to block 510.

In block 510, a first set of indexed samples from the received (and potentially preprocessed) radar signals is stored, such as in radar data cube storage associated with the radar system (e.g., radar data cube storage 322 of FIG. 3). In the depicted embodiment, such samples correspond to specific time instances along a slow-time axis and are selected according to a predetermined pattern. The indexed samples stored in this step form the basis for subsequent calculations and data reconstruction. The routine proceeds to block 515.

At block 515, the radar system omits from storage a second set of indexed samples from the received radar signals. These omitted samples also correspond to specific time instances along the slow-time axis, but are not stored directly. Instead, their information is later reconstructed based on the stored samples and on calculated cross-correlation values. The routine proceeds to block 520.

At block 520, the radar system calculates and stores a set of cross-correlation values for each omitted indexed sample of the second set. In the depicted embodiment, these cross-correlation values are computed between the omitted sample and a plurality of neighboring indexed samples from the first set within a local sliding window context. The cross-correlation values capture the relationships between the omitted and stored samples, enabling later reconstruction of the omitted samples. The routine proceeds to block 525.

In block 525, the omitted indexed samples of the second set are reconstructed using the stored cross-correlation values and the stored indexed samples of the first set. The reconstruction process involves solving a system of equations characterized by a Toeplitz matrix, utilizing the cross-correlation values and the stored samples. This enables the omitted samples to be accurately estimated. The routine proceeds to block 530.

At block 530, a range-velocity map is generated based at least in part on the stored samples of the first set and the reconstructed samples of the second set. The range-velocity map visually represents the range and velocity information for the detected target objects, providing a comprehensive overview of the target objects' positions and motions. It will be appreciated that in embodiments in which samples are collected and omitted along the fast-time axis rather than the slow-time axis of the radar data cube, the radar system generates a range-Doppler map as a result of such samples' reconstruction (rather than a range-velocity map), providing a two-dimensional representation of target objects' distances and relative velocities. Similarly, in embodiments in which samples are collected and omitted along the spatial axis, the radar system generates a range-angle map, providing a two-dimensional representation of objects' distances and their angular positions.

In some embodiments, certain aspects of the techniques described above may implemented by one or more processors of a processing system executing software. The software comprises one or more sets of executable instructions stored or otherwise tangibly embodied on a non-transitory computer readable storage medium. The software can include the instructions and certain data that, when executed by the one or more processors, manipulate the one or more processors to perform one or more aspects of the techniques described above. The non-transitory computer readable storage medium can include, for example, a magnetic or optical disk storage device, solid state storage devices such as Flash memory, a cache, random access memory (RAM) or other non-volatile memory device or devices, and the like. The executable instructions stored on the non-transitory computer readable storage medium may be in source code, assembly language code, object code, or other instruction format that is interpreted or otherwise executable by one or more processors.

A computer readable storage medium may include any storage medium, or combination of storage media, accessible by a computer system during use to provide instructions and/or data to the computer system. Such storage media can include, but is not limited to, optical media (e.g., compact disc (CD), digital versatile disc (DVD), Blu-Ray disc), magnetic media (e.g., floppy disk, magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed are not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A method, comprising:
receiving radar signals reflected from one or more objects;
sampling the received radar signals to produce a first set of indexed samples and a second set of indexed samples;
storing, at a computer-readable memory device, the first set of indexed samples;
omitting the second set of indexed samples from the computer-readable memory device;
calculating and storing sets of cross-correlation values for the second set of indexed samples;
reconstructing the second set of indexed samples using the stored sets of cross-correlation values and the stored first set of indexed samples; and
generating a radar map based at least in part on the reconstructed second set of indexed samples and the stored first set of indexed samples.

2. The method of claim 1, wherein calculating a set of cross-correlation values for a respective indexed sample of the second set of indexed samples comprises calculating cross-correlation values between the indexed sample and a subset of indexed samples of the first set of indexed samples that neighbor the respective indexed sample.

3. The method of claim 2, wherein calculating and storing the sets of cross-correlation values comprises selecting, for the respective indexed sample of the second set of indexed samples, a local sliding window context that includes the subset of indexed samples of the first set of indexed samples that neighbor the respective indexed sample.

4. The method according to any preceding claim, wherein each indexed sample corresponds to a specific time instance along a slow-time axis, and wherein generating the radar map comprises generating a range-velocity map.

5. The method according to any preceding claim, wherein the first set of indexed samples comprises odd-indexed samples from the received radar signals, and wherein the second set of indexed samples comprises even-indexed samples from the received radar signals.

6. The method according to any preceding claim, wherein the method is performed by a system-on-chip (SoC) integrated circuitry device that comprises the computer-readable memory device, wherein storing the first set of indexed samples comprises storing the first set of indexed samples in a radar data cube storage of the computer-readable memory device, and wherein storing the sets of cross-correlation values comprises storing the sets of cross-correlation values in the radar data cube storage of the computer-readable memory device.

7. The method according to any preceding claim, wherein reconstructing the second set of indexed samples comprises solving a system of equations **characterized by** a Toeplitz matrix based on the sets of cross-correlation values and the first set of indexed samples.

8. A radar system, comprising:
a computer-readable memory device;
a transceiver configured to:
receive radar signals reflected from one or more objects; and
sample the received radar signals to produce a first set of indexed samples and a second set of indexed samples; and
a radar processing unit configured to:
store, at the computer-readable memory device, the first set of indexed samples;
omit the second set of indexed samples from storage at the computer-readable memory device;
calculate and store sets of cross-correlation values for the second set of indexed samples;
reconstruct the second set of indexed samples using the stored sets of cross-correlation values and the stored first set of indexed samples; and
generate a radar map based at least in part on the reconstructed second set of indexed samples and the stored first set of indexed samples.

9. The radar system of claim 8, wherein to calculate a set of cross-correlation values of the sets of cross-correlation values for an indexed sample of the second set of indexed samples, the radar processing unit is configured to calculate cross-correlation values between the indexed sample of the second set of indexed samples and a subset of indexed samples of the first set of indexed samples that neighbor the indexed sample.

10. The radar system of claim 8 or claim 9, wherein each indexed sample corresponds to a specific time instance along a slow-time axis, and wherein the radar map comprises a range-velocity map.

11. The radar system according to any of claims 8 to 10, wherein, to calculate and store the set of cross-correlation values, the processing unit is further configured to:
select, for the indexed sample of the second set of indexed samples, a local sliding
window context that includes the subset of indexed samples of the first set of indexed samples that neighbor the indexed sample.

12. The radar system according to any of claims 8 to 11, wherein the first set of indexed samples comprises odd-indexed samples from the received radar signals, and wherein the second set of indexed samples comprises even-indexed samples from the received radar signals.

13. The radar system according to any of claims 8 to 12, further comprising a system-on-chip (SoC) that includes the transceiver, the radar processing unit, and the computer-readable memory device.

14. The radar system according to any of claims 8 to 13, wherein, to reconstruct the second set of indexed samples, the radar processing unit is configured to solve a system of equations **characterized by** a Toeplitz matrix based on the sets of cross-correlation values and the first set of indexed samples.

15. A non-transitory computer readable medium storing a set of executable instructions that, when executed by one or more processors, manipulate the one or more processors to:
receive radar signals reflected from one or more objects;
sampling the received radar signals to produce a first set of indexed samples and a second set of indexed samples;
store, at a computer-readable memory device, the first set of indexed samples;
omit the second set of indexed samples from the computer-readable memory device;
calculate and store sets of cross-correlation values for the second set of indexed samples,;
reconstruct the second set of indexed samples using the stored sets of cross-correlation values and the stored first set of indexed samples; and
generate a radar map based at least in part on the reconstructed second set of indexed samples and the stored first set of indexed samples.
